(19) Europäisches Patentamt
European Patent Office
Office européen des brevets

(11) **EP 4 549 968 B1**

(12) **EUROPEAN PATENT SPECIFICATION**

(45) Date of publication and mention
of the grant of the patent:
**22.04.2026  Bulletin 2026/17**

(21) Application number: **23865920.5**

(22) Date of filing: **15.09.2023**

(51) International Patent Classification (IPC):
**G01R 31/3835** (2019.01)    **G01R 31/392** (2019.01)
**G01R 31/396** (2019.01)

(52) Cooperative Patent Classification (CPC):
**G01R 31/3835; B60L 58/10; G01R 19/10;
G01R 19/165; G01R 31/36; G01R 31/392;
G01R 31/396; Y02E 60/10**

(86) International application number:
**PCT/KR2023/013987**

(87) International publication number:
**WO 2024/058625 (21.03.2024 Gazette 2024/12)**

(54) **BATTERY DIAGNOSIS APPARATUS, BATTERY DIAGNOSIS METHOD, BATTERY PACK, AND VEHICLE**

BATTERIEDIAGNOSEVORRICHTUNG, BATTERIEDIAGNOSEVERFAHREN, BATTERIEPACK UND FAHRZEUG

APPAREIL DE DIAGNOSTIC DE BATTERIE, PROCÉDÉ DE DIAGNOSTIC DE BATTERIE, BLOC-BATTERIE ET VÉHICULE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.09.2022  KR 20220117336**

(43) Date of publication of application:
**07.05.2025  Bulletin 2025/19**

(60) Divisional application:
**26164475.1**

(73) Proprietor: **LG Energy Solution, Ltd.
Seoul 07335 (KR)**

(72) Inventor: **YEOM, In-Cheol
Daejeon 34122 (KR)**

(74) Representative: **Plasseraud IP
104 Rue de Richelieu
CS92104
75080 Paris Cedex 02 (FR)**

(56) References cited:
JP-A- 2014 107 156      JP-A- 2020 169 968
JP-A- 2022 066 682      KR-A- 20200 030 467
KR-A- 20220 078 358    US-A1- 2022 026 499
US-A1- 2022 128 631

• **PENG XIAOMENG ET AL: "Robust Physics Guided Data-Driven Fleet Battery Pack Fault Detection Under Dynamic Operating Conditions", 2022 IEEE 18TH INTERNATIONAL CONFERENCE ON AUTOMATION SCIENCE AND ENGINEERING (CASE), IEEE, 20 August 2022 (2022-08-20), pages 971 - 978, XP034216045, DOI: 10.1109/CASE49997.2022.9926643**

**Description**

TECHNICAL FIELD

The present disclosure relates to a technology for diagnosing a voltage abnormality of a battery.

The present application claims priority to Korean Patent Application No. 10-2022-0117336 filed on September 16, 2022 in the Republic of Korea.

BACKGROUND ART

Recently, there has been a rapid increase in the demand for portable electronic products such as laptop computers, video cameras and mobile phones, and with the extensive development of electric vehicles, energy storage systems, robots and satellites, many studies are being made on high performance batteries that can be recharged repeatedly.

Currently, commercially available batteries include nickel-cadmium batteries, nickel-hydrogen batteries, nickel-zinc batteries, lithium ion batteries and the like. Among them, lithium batteries have little or no memory effect, and thus they are gaining more attention than nickel-based batteries for their advantages that recharging can be done whenever it is convenient, the self-discharge rate is very low and the energy density is high.

Recently, as applications requiring high voltage (e.g., energy storage systems, electric vehicles) become widespread, the need for diagnostic technology that accurately detects voltage abnormalities in each of the plurality of battery cells connected in series within a battery pack is increasing.

The voltage abnormality of a battery cell refers to a fault condition in which the cell voltage drops and/or rises abnormally due to internal short-circuit, external short-circuit, failure of the voltage sensing line, or poor connection with the charging/discharging line.

Conventionally, a simple method was used to diagnose a voltage abnormality of a battery cell by determining whether the difference between cell voltages measured at two different time points exceeds a threshold value. This method has the advantage of not requiring a high-performance processor because the amount of data calculation is not large.

However, since the voltage of a battery cell also depends on temperature, current, and/or SOH (State Of Health) of the battery cell, it is not easy to accurately diagnose the voltage abnormality of the battery cell just through the process of comparing the difference of the voltages of the battery cell measured at different time points with the threshold value.

In addition, if the voltage difference between the battery cells is lower than or equal to the threshold value but the voltage slope of the battery cell shows abnormal behavior, for example, when lithium plating (Li-plating) occurs on the negative electrode of a lithium battery, there is a limit in that an abnormality in cell voltage cannot be detected.

US 2022/128631 A1 discloses a battery diagnosis apparatus wherein cell voltage differences which are the differences between individual cell voltages and maximum and minimum cell voltages of the pack are determined. These are then modified taking into account operating conditions and used to estimate the balance state of the battery.

DISCLOSURE

Technical Problem

The present disclosure is designed to solve the problems of the related art, and therefore the present disclosure is directed to providing a battery diagnosis apparatus, a battery diagnosis method, a battery pack, and a vehicle, which may efficiently and accurately diagnose a voltage abnormality of a battery cell using the tendency of a voltage change slope of the battery cell.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis apparatus according to claim 1.

The p may be 1 or a natural number of 2 or more.

The criterion value may be 1 or a natural number of 2 or more.

The control circuit may be configured to select the plurality of cell voltage sets from the time series data for the cell voltage while increasing the k by 1 from 1 to n-2 (n is the number of voltage data included in the time series data).

The control circuit may be configured to perform the control logics (i) to (iv) when the operation state of the battery cell switches from a charging or discharging state to a no-load state.

The battery diagnosis apparatus may further comprise an interface unit operably coupled with the control circuit to support communication with an external device.

The control circuit may be configured to transmit a diagnosis result to an external device through the interface unit when the battery cell is diagnosed as exhibiting a voltage abnormality.

The battery diagnosis apparatus may further comprise an interface unit operably coupled with the control circuit; and an output device operably coupled with the interface unit.

The control circuit may be configured to output a diagnosis result visually or audibly through the output device when the battery cell is diagnosed as exhibiting a voltage abnormality.

In another aspect of the present disclosure, there is also provided a battery pack comprising the battery diagnosis apparatus, and a vehicle comprising the battery pack.

In another aspect of the present disclosure, there is also provided a battery diagnosis method, comprising: (a) receiving a voltage signal indicating a cell voltage of a battery cell from a voltage sensing circuit and recording time series data for the cell voltage in a storage medium; (b) selecting $k^{th}$, $k+1^{th}$, and $k+2^{th}$ measured cell voltage set from the time series data as diagnostic data (k is an index indicating a measurement order of the cell voltage and is a natural number of 1 or more to which a plurality of values is assigned); (c) determining a first voltage difference between the $k^{th}$ cell voltage and the $k+1^{th}$ cell voltage and a second voltage difference between the $k+1^{th}$ cell voltage and the $k+2^{th}$ cell voltage; and (d) diagnosing the battery cell as exhibiting a voltage abnormality, when, for a plurality of cell voltage sets, a count number of cell voltage sets for which a normal diagnosis condition where the p square of the first voltage difference (p is a natural number of 1 or more) is greater than the p square of the second voltage difference is not established is greater than or equal to a criterion value.

The p may be 1 or a natural number of 2 or more.

The criterion value may be 1 or a natural number of 2 or more.

The plurality of cell voltage sets may be selected from the time series data for the cell voltage while increasing the k by 1 from 1 to n-2 (n is the number of voltage data included in the time series data).

The steps (a) to (d) may be performed when the operation state of the battery cell switches from a charging or discharging state to a no-load state.

The battery diagnosis method may further comprise: transmitting a diagnosis result to an external device when the battery cell is diagnosed as exhibiting a voltage abnormality.

The battery diagnosis method may further comprise: outputting a diagnosis result visually or audibly through an output device when the battery cell is diagnosed as exhibiting a voltage abnormality.

Advantageous Effects

According to the present disclosure, a battery cell exhibiting voltage abnormality may be easily diagnosed by analyzing the tendency of a cell voltage slope between continuously measured cell voltages using a simple mathematical operation.

According to another embodiment of the present disclosure, since the calculation method used for battery diagnosis is not complicated, a processor with high specification is not required.

According to still another embodiment of the present disclosure, the reliability of voltage abnormality diagnosis may be improved by using mathematical operation that may amplify the tendency of the cell voltage slope.

According to still another embodiment of the present disclosure, a battery cell that exhibit abnormal voltage behavior may be reliably identified even if the difference between voltages measured at different time points is not large.

The effects of the present disclosure are not limited to the above-mentioned effects, and these and other effects not mentioned herein will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is an exemplary diagram showing a vehicle according to an embodiment of the present disclosure.

FIG. 2a is a diagram showing a part of a cell voltage profile exhibited by a normal battery cell when a battery cell being charged is switched to a no-load state according to an embodiment of the present disclosure as a graph, and is a diagram for deriving a formula used to diagnose voltage abnormality.

FIG. 2b is a diagram showing a part of a cell voltage profile exhibited by a normal battery cell when a battery cell being discharged is switched to a no-load state according to an embodiment of the present disclosure as a graph, and is a diagram for deriving a formula used to diagnose voltage abnormality.

FIG. 3a is a graph showing an example of time series data for a cell voltage of a battery cell with a normal voltage according to an embodiment of the present disclosure.

FIG. 3b is a graph showing an example of time series data for a cell voltage of a battery cell with a voltage abnormality according to an embodiment of the present disclosure.

FIG. 4a is a graph showing an example of time series data for a cell voltage of a battery cell with a normal voltage according to another embodiment of the present disclosure.

FIG. 4b is a graph showing an example of time series data for a cell voltage of a battery cell with a voltage abnormality according to another embodiment of the present disclosure.

FIG. 5 is a flowchart for illustrating a battery diagnosis method according to an embodiment of the present disclosure.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

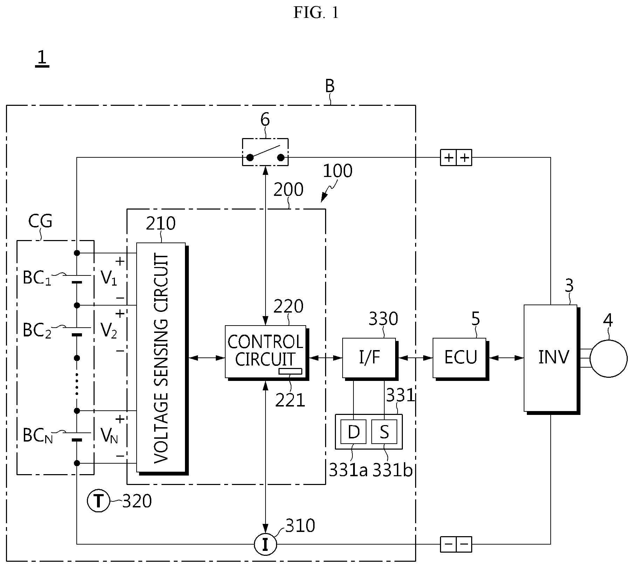

FIG. 1 is an exemplary diagram showing a vehicle according to an embodiment of the present disclosure.

Referring to FIG. 1, the vehicle 1 includes a battery pack B, an inverter 3, an electric motor 4 and a vehicle controller 5.

The vehicle 1 refers to a vehicle that can be driven by a motor using electrical energy provided by the battery pack B. As an example, the vehicle 1 may be an electric vehicle, a plug-in hybrid vehicle, or a hybrid vehicle.

The battery pack B includes a cell group CG, a switch 6, and a battery management system 100.

The cell group CG may be coupled to the inverter 3 through a pair of power terminals provided to the battery pack B. The cell group CG includes a plurality of battery cells $BC_1$ to $BC_N$ connected in series. Here, N is a natural number of 2 or more and represents the number of battery cells. The battery cell $BC_i$ is not particularly limited by its type as long as it enables repeated charging and discharging, like a lithium-ion battery cell. i is an index for battery cell identification. i is a natural number from 1 to N.

The switch 6 is connected in series to the cell group CG. The switch 6 is installed in the current path for charging and discharging the cell group CG. The switch 6 is controlled to turn on and off in response to a switching signal from the battery management system 100. The switch 6 may be a mechanical relay that turns on and off by the magnetic force of the coil, or a semiconductor switch such as a MOSFET (Metal Oxide Semiconductor Field Effect transistor).

The inverter 3 is provided to convert the direct current (DC) from the cell group CG to alternating current (AC) in response to a command from the battery management system 100 or the vehicle controller 5. The electric motor 4 may be, for example, a 3-phase AC motor. The electric motor 4 is driven using the AC power provided from the inverter 3.

The battery management system 100 is provided to take charge of overall control related to charging and discharging of the cell group CG while the vehicle 1 is operating. Here, the operation of the vehicle 1 may include running, stop during movement, parking, or the like of the vehicle 1.

The battery management system 100 includes a battery diagnosis apparatus 200. The battery management system 100 may further include at least one of a current sensor 310, a temperature sensor 320, and an interface unit 330.

The battery diagnosis apparatus 200 is provided to diagnose voltage abnormalities in each of the plurality of battery cells $BC_1$ to $BC_N$ while the vehicle 1 is operating. The battery diagnosis apparatus 200 includes a voltage sensing circuit 210 and a control circuit 220.

The voltage sensing circuit 210 is connected to the positive electrode and negative electrode of each of the plurality of battery cells $BC_1$ to $BC_N$ through a plurality of voltage sensing lines. The voltage sensing circuit 210 is configured to measure the cell voltage across both ends of each battery cell ($BC_i$) at regular time intervals under the control of the control circuit 220 while the vehicle 1 is operating and generate a voltage signal indicating the measured cell voltage. The voltage sensing circuit 210 may include a common voltage measuring circuit known in the art. The voltage measurement circuit may include a multiplexing circuit that may sequentially select battery cells subject to voltage measurement at time intervals, a filter circuit that removes noise from the voltage measurement signal, an amplifier circuit that amplifies the voltage measurement signal, or the like.

The current sensor 310 is connected in series to the cell group CG through a current path. The current sensor 310 is configured to detect the battery current flowing through the cell group CG at regular time intervals under the control of the control circuit 220 while the vehicle 1 is operating and generate a current signal indicating the detected battery current. The current sensor 310 may be a common sensor known in the art, such as a sense resistor or a Hall sensor. The current flowing through the cell group CG may be a charging current or a discharging current.

The temperature sensor 320 is configured to detect the temperature of the cell group CG at regular time intervals under the control of the control circuit 220 while the vehicle 1 is operating and generate a temperature signal indicating the detected temperature. The temperature sensor 320 may be a common sensor known in the art, such as a thermocouple. The temperature sensor 320 may be installed at multiple points within the battery pack B to independently measure the temperature of each battery cell ($BC_i$).

The control circuit 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The control circuit 220 may have a storage medium 221. The storage medium 221 may be, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The storage medium 221 may store data and programs required for computation by the control circuit 220. The storage medium 221 may accumulatively store data indicating the result of computation, for example diagnosis result, by the control circuit 220 together with a time stamp.

The control circuit 220 may be operably coupled to the voltage sensing circuit 210, the temperature sensor 320, the current sensor 310, the interface unit 330, and/or the switch 6. The control circuit 220 may collect sensing signals from the voltage sensing circuit 210, the current sensor 310, and the temperature sensor 320 at regular time intervals while the vehicle 1 is operating. The sensing signals include voltage signal, current signal, and/or temperature signal. The voltage signal, current signal, and/or temperature signal may be collected using a synchronized measurement method. The control circuit 220 may convert the voltage signal and/or current signal and/or temperature signal into digital data and accumulatively store them in the storage medium 221 to generate time series data regarding the voltage and/or current and/or temperature of the battery cell. Therefore, the time series data regarding the cell voltage of each battery cell ($BC_i$), the current flowing through the battery pack B, and the temperature of the battery pack B may be accumulatively stored in the storage medium 221.

The time series data for voltage may include a number of voltage data corresponding to the number of voltage measurements. One voltage data includes a measurement time point and a measured voltage value. The time series data for current includes a number of current data corresponding to the number of current measurements. One current data includes a measurement time point and a measured current value. The time series data for temperature includes a number of temperature data corresponding to the number of temperature measurements. One temperature data includes a measurement time point and a measured temperature value.

The control circuit 220 may identify whether the battery cell is in charging, in discharging, or in a no-load state by referring to the magnitude and sign of the current measured through the current sensor 310.

Specifically, the control circuit 220 may identify that the battery cell is in a no-load state when the magnitude of the current measured through the current sensor 310 through is 0. Also, the control circuit 220 may identify that the battery cell is in discharging when the magnitude of the current measured through the current sensor 310 is greater than 0 and the sign of the current value is positive. Also, the control circuit 220 may identify that the battery cell is in charging when the magnitude of the current measured through the current sensor 310 is greater than 0 and the sign of the current value is negative.

The interface unit 330 may include a communication circuit configured to support wired or wireless communication between the control circuit 220 and the vehicle controller 5 (for example, an Electronic Control Unit (ECU)). The wired communication may be, for example, controller area network (CAN) communication, and the wireless communication may be, for example, ZigBee or Bluetooth communication. The communication protocol is not limited to a particular type and may include any communication protocol capable of supporting wired/wireless communication between the control circuit 220 and the vehicle controller 5.

The interface unit 330 may be coupled with an output device 331 that provides information received from the vehicle controller 5 and/or the control circuit 220 in a form recognizable to the user. The output device 331 may include a display 331a and a speaker 331b.

The interface unit 330 may include a video I/O interface and an audio I/O interface to visually or audibly output the diagnosis result through the output device 331.

The vehicle controller 5 may control the inverter 3 based on battery information (e.g., voltage, current, temperature, SOC) collected through communication with the battery management system 100.

The control circuit 220 may record the time series data for the cell voltage of each battery cell ($BC_i$) measured by the voltage sensing circuit 210 in the storage medium 221 while the vehicle 1 is operating, and diagnose whether the battery cell exhibits a voltage abnormality using the corresponding time series data.

Specifically, the control circuit 220 selects $k^{th}$, $k+1^{th}$, and $k+2^{th}$ measured cell voltage set from the time series data for the cell voltage recorded in the storage medium 221 as diagnostic data. Here, k is an index representing a measurement order of the cell voltage and is a natural number from 1 to n. n is the number of total cell voltages included in the time series data. For convenience of explanation, the $k^{th}$ measured voltage value is expressed as $V_k$.

When k is 1, the control circuit 220 selects a cell voltage set $V_1$, $V_2$, and $V_3$ from the time series data for the cell voltage. When k is 2, the control circuit 220 selects a cell voltage set $V_2$, $V_3$, and $V_4$ from the time series data for the cell voltage. When k is any m, the control circuit 220 selects a cell voltage set $V_m$, $V_{m+1}$, and $V_{m+2}$ from the time series data for the cell voltage. m is a natural number of 3 to n-2.

The control circuit 220 also determines a first voltage difference between the $k^{th}$ cell voltage and the $k+1^{th}$ cell voltage and a second voltage difference between the $k+1^{th}$ cell voltage and the $k+2^{th}$ cell voltage.

The control circuit 220 determines whether a normal diagnosis condition where the p square of the first voltage difference (p is a natural number of 1 or more) is greater than the p square of the second voltage difference is established for each cell voltage set selected from the time series data for the cell voltage, and counts the number of cell voltage sets that do not satisfy the normal diagnosis condition among the cell voltage sets selected from the time series data for the cell voltage.

The control circuit 220 may diagnose the battery cell as exhibiting a voltage abnormality when the number of cell voltage sets that do not satisfy the normal diagnosis condition is greater than or equal to a criterion value.

The criterion value may be set to a natural number of 1 or more. In applications where a high level of diagnostic sensitivity is required, the criterion value may be set to a low level, for example 1 to 3. Meanwhile, in applications where a moderate level of diagnostic sensitivity is required, the criterion value may be set to, for example, 4 or higher.

Preferably, the appropriate level of the criterion value in applications to which the present disclosure applies may be determined through trial and error.

In one aspect, the criterion value may be increased in applications where voltage noise is easily introduced into the voltage sensing circuit 210. When the accuracy of cell voltage measurement is lowered due to voltage noise, if the criterion value is small, battery cells exhibiting normal voltage behavior may be incorrectly diagnosed as exhibiting a voltage abnormality.

**In** another aspect, the criterion value may be decreased if the voltage sensing circuit 210 is designed to have robustness against voltage noise.

The diagnosis logic of the control circuit 220 described above is preferably executed after the battery cell is switched from a charging or discharging state to a no-load state. The no-load state refers to a state in which the magnitude of the charging current or discharging current is substantially 0. The no-load state may include a case where the magnitude of the charging current or discharging current is very small. The diagnosis logic of the control circuit 220 may be executed even when the battery cell is in a charging or discharging state.

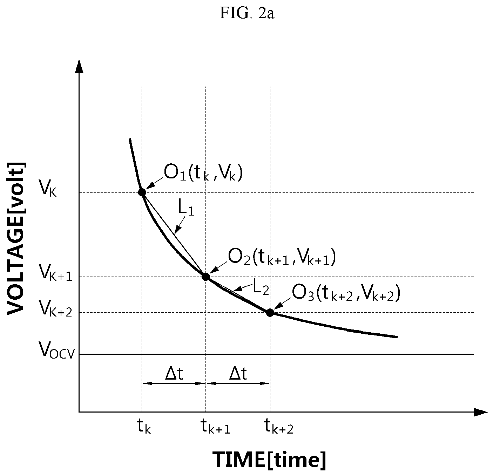

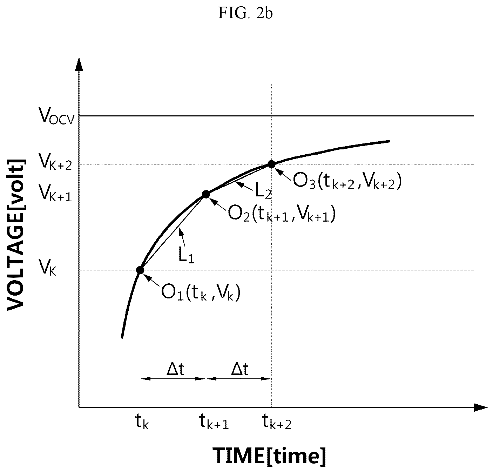

FIGS. 2a and 2b are diagrams for deriving a formula representing the normal diagnosis condition of a battery cell using the voltage behavior of a battery cell without voltage abnormality.

The voltage profile shown in FIG. 2a corresponds to a part of the cell voltage profile exhibited by a normal battery cell without voltage abnormality when the battery cell being charged is switched to a no-load state according to an embodiment of the present disclosure.

The voltage profile shown in FIG. 2b corresponds to a part of the cell voltage profile exhibited by a normal battery cell without voltage abnormality when a battery cell being discharged is switched to a no-load state according to an embodiment of the present disclosure.

As shown in FIGS. 2a and 2b, when a battery cell without voltage abnormality comes into a no-load state while being charged or discharged, the polarization of the electrodes is relaxed and the cell voltage tends to gradually converge to a stabilization voltage ($V_{OCV}$). Specifically, when the battery cell comes into a no-load state while being charged, the cell voltage gradually lowers and converges to the stabilization voltage ($V_{OCV}$) immediately after entering the no-load state. Conversely, when the battery cell comes into the no-load state while being discharged, the cell voltage gradually increases and converges to the stabilization voltage ($V_{OCV}$) immediately after entering the no-load state. Here, the stabilization voltage ($V_{OCV}$) refers to an open circuit voltage corresponding to the current state of charge of the battery cell. Also, at the beginning of the no-load state, the IR voltage of the battery cell becomes 0, so the range of change in cell voltage is relatively large.

Referring to FIGS. 2a and 2b, any cell voltage set $V_k$, $V_{k+1}$, $V_{k+2}$ selected from the time series data for the cell voltage for a battery cell in a no-load state may be expressed as three points $O_1$, $O_2$, $O_3$ on the cell voltage profile.

The measurement time points of continuously measured cell voltages $V_k$, $V_{k+1}$, $V_{k+2}$ are $t_k$, $t_{k+1}$, $t_{k+2}$, respectively, and the measurement period of the cell voltage is constant as $\triangle t$. The measurement period of the cell voltage may be several msec to several seconds.

If a battery cell in a no-load state shows normal voltage behavior like the cell voltage profile in FIGS. 2a and 2b, even for an arbitrary cell voltage set, the slope of a line segment $L_1$ connecting two points $O_1$ and $O_2$ is relatively larger than the slope of a line segment L2

connecting two points $O_2$ and $O_3$.

This is because the cell voltage profile of a battery cell that does not exhibit a voltage abnormality tends to converge toward the stabilization voltage ($V_{OCV}$) while gradually increasing or gradually decreasing toward the stabilization voltage ($V_{OCV}$). These characteristics may be expressed by Formula 1 below.

<Formula 1>

$$|(V_{k+1} - V_k)|/|\triangle t| > |(V_{k+2} - V_{k+1})|/|\triangle t|$$

Also, if the right and left terms of Formula 1 are multiplied by $|\triangle t|$, Formula 1 may be expressed as Formula 2.

<Formula 2>

$$|(V_{k+1} - V_k)| > |(V_{k+2} - V_{k+1})|$$

In Formula 2, $|(V_{k+1} - V_k)|$ corresponds to an absolute difference between the $k^{th}$ measured cell voltage $V_k$ and the $k+1^{th}$ measured cell voltage $V_{k+1}$, and may be defined as a first voltage difference $\triangle V_{1,k}$.

Similarly, $|(V_{k+2} - V_{k+1})|$ corresponds to an absolute difference between the $k+1^{th}$ measured cell voltage $V_{k+1}$ and the $k+2^{th}$ measured cell voltage $V_{k+2}$, may be defined as a second voltage difference $\triangle V_{2,k}$.

By the definitions of the first voltage difference and the second voltage difference, Formula 2 may be expressed as Formula 3.

<Formula 3>

$$\triangle V_{1,k} > \triangle V_{2,k}$$

The inequality of Formula 3 may still be established even if the p squared power is applied to each of the first voltage difference and the second voltage difference, as shown in Formula 4 below.

<Formula 4>

$$\triangle V_{1,k}^{p} > \triangle V_{2,k}^{p}$$

(where p is a natural number of 1 or more)

Formula 4 may be used as a normal diagnosis condition when trying to diagnose a voltage abnormality of the battery cell using any cell voltage set $V_k$, $V_{k+1}$, $V_{k+2}$ selected from the cell voltage profile for the battery cell.

In Formula 4, p is a natural number of 1 or more. Preferably, p may be 2 or more. If p is 2 or more, when the first voltage difference and/or the second voltage difference has a value greater than 1, the value may be amplified to a larger value. Also, if p is 2 or more, when the first voltage difference and/or the second voltage difference has a value less than 1, the value may be attenuated to a smaller value. Therefore, if p is 2 or more, the possibility of errors occurring in the process of determining whether the inequality of Formula 4 is satisfied may be reduced. This is because a value greater than 1 is amplified to a larger value, and a value less than 1 is attenuated to a smaller value, so that the difference between the first voltage difference ($\triangle V_{1,k}$) and the second voltage difference ($\triangle V_{2,k}$) increases.

When the number of total cell voltages included in the time series data is n, the number of total cell voltage sets that may be selected from the time series data is n-2. Therefore, the control circuit 220 may determine whether the normal diagnosis condition of Formula 4 is satisfied for a total of n-2 cell voltage sets, and accumulatively count the number of cell voltage sets that do not satisfy the normal diagnosis condition.

The control circuit 220 may also record the counting result of the cell voltage sets that do not satisfy the normal diagnosis condition in the storage medium 221. Also, the control circuit 220 may diagnose the battery cell as exhibiting a voltage abnormality when the number of cell voltage sets that do not satisfy the normal diagnosis condition is greater than or equal to a criterion value, and record the diagnosis result in the storage medium 221. The diagnosis result may include a time point at which the voltage abnormality of the battery cell is diagnosed and identification information (serial number, etc.) of the battery cell at which the voltage abnormality is exhibited.

The control circuit 220 may also output the diagnosis result visually or audibly through the output device 331 operably coupled with the interface unit 330.

In one example, the control circuit 220 may output the diagnosis result to a graphical user interface through the display 331a. In another example, the control circuit 220 may output the diagnosis result as a voice through the speaker 331b. Preferably, the diagnosis result may include a warning message that the battery pack B requires detailed inspection. When the diagnosis result is output visually or audibly, it is also possible to output only a warning message.

The control circuit 220 may also transmit the diagnosis result to an external device through wired or wireless communication supported by the interface unit 330.

In one example, the external device may be a vehicle controller 5. When the vehicle controller 5 receives the diagnosis result, a warning message may be output in a graphical user interface through an integrated display panel mounted on the vehicle 1. In this case, a driver may bring the vehicle 1 to a service center and conduct a thorough inspection on the battery pack B. If a battery cell exhibiting a voltage abnormality is found through the thorough inspection, the battery cell may be replaced with another battery cell.

In another example, the external device may be an on-board diagnosing device (not shown) connected through the interface unit 330. The on-board diagnosing device is a device that checks the status of various parts included in the vehicle 1. When the on-board diagnosing device is connected through the interface unit 330, the control circuit 220 may read the diagnosis result regarding the voltage abnormality of the battery cell stored in the storage medium 221 and transmit it to the on-board diagnosing device through the interface unit 330. Then, an operator may recognize the diagnosis result output through the display of the on-board diagnosing device and perform a thorough inspection on the battery pack B. Also, if a battery cell exhibiting a voltage abnormality is found, the operator may replace the corresponding battery cell with another battery cell.

The on-board diagnosing device may execute the diagnosis logic of the control circuit 220 described above. In this case, the on-board diagnosing device may receive the time series data for the cell voltage for each battery cell recorded in the storage medium 221 from the control circuit 220. The time series data for the cell voltage may be measured after the battery pack B switches from a charging or discharging state to a no-load state. The on-board diagnosing device may generate the voltage abnormality diagnosis result for each battery cell and output it on the display.

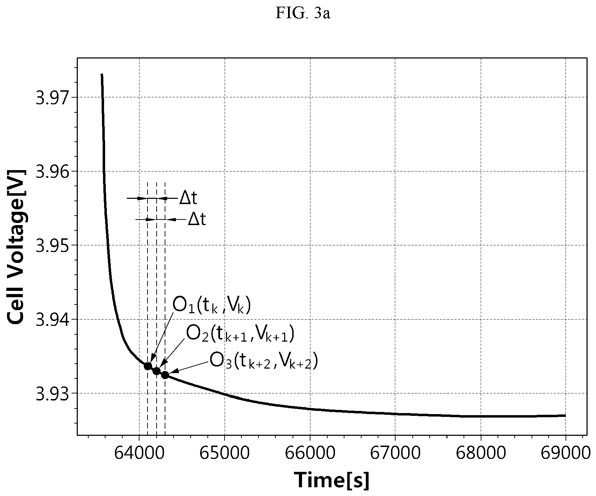

FIG. 3a is a graph showing an example of time series data for a cell voltage of a battery cell with a normal voltage according to an embodiment of the present disclosure.

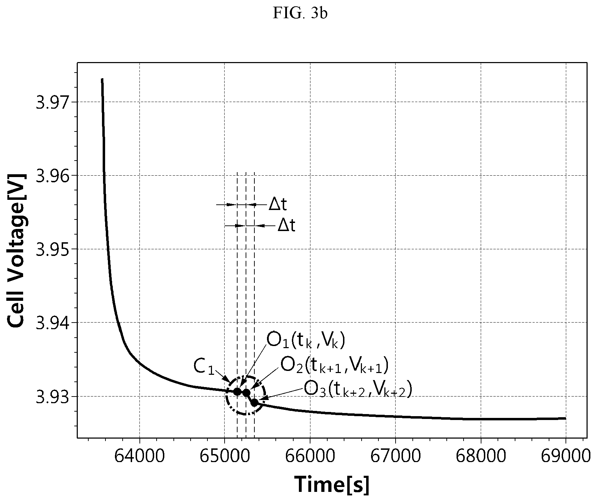

FIG. 3b is a graph showing an example of time series data for a cell voltage of a battery cell with a voltage abnormality according to an embodiment of the present disclosure.

The cell voltage profile of FIGS. 3a and 3b may appear when the battery cell switches from a charging state to a no-load state. Alternatively, the cell voltage profile of FIGS. 3a and 3b may appear when the battery cell is in discharging.

Referring to FIG. 3a, the cell voltage of a battery cell with a normal voltage gradually decreases over time without showing any unusual cell voltage behavior. Therefore, even if any arbitrary cell voltage set $V_k$, $V_{k+1}$, $V_{k+2}$ is selected from the time series data for the cell voltage, the cell voltage set may satisfy the normal diagnosis condition of Formula 4. Therefore, when the time series data for the cell voltage shows the profile as shown in FIG. 3a, the count number of the cell voltage sets that do not satisfy the normal diagnosis condition may be 0.

Referring to FIG. 3b, a battery cell showing a voltage abnormality may show an unusual behavior (see $C_1$) in a specific time section. For example, when the battery cell is a lithium-ion battery, if lithium plating occurs at the negative electrode, the change slope of the cell voltage shows an unusual behavior. In other words, there appears a section where the cell voltage slope rather increases while the cell voltage slope is gradually decreasing. Therefore, if the cell voltage set $V_k$, $V_{k+1}$, $V_{k+2}$ is selected in the time section in which an abnormal change pattern of the cell voltage appears, the cell voltage set may not satisfy the normal diagnosis condition of Formula 4. Therefore, when the time series data for the cell voltage shows the profile shown in FIG. 3b, the count number of the cell voltage set that does not satisfy the normal diagnosis condition may be 1. Of course, if an abnormal change pattern of the cell voltage appears at a plurality of locations in the cell voltage profile, the count number of the cell voltage set that does not satisfy the normal diagnosis condition may be increased to the number corresponding to the plurality of locations.

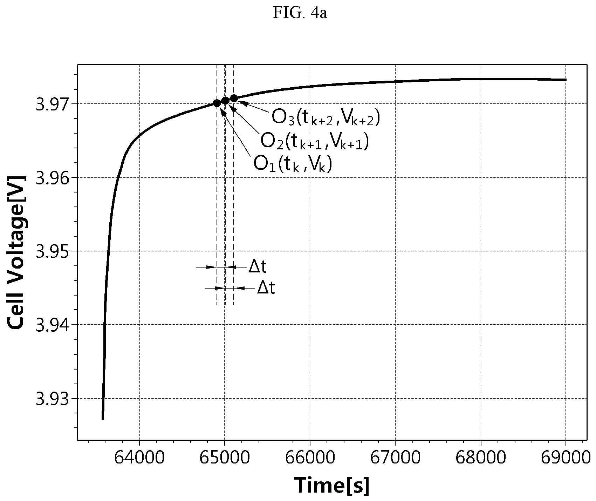

FIG. 4a is a graph showing an example of time series data for a cell voltage of a battery cell with a normal voltage according to another embodiment of the present disclosure.

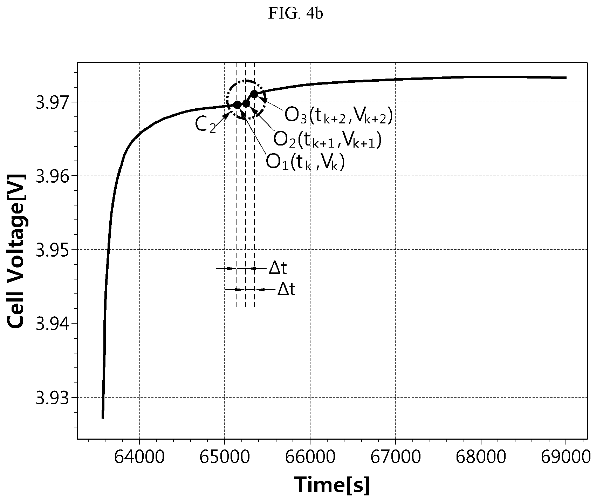

FIG. 4b is a graph showing an example of time series data for a cell voltage of a battery cell with a voltage abnormality according to another embodiment of the present disclosure.

The cell voltage profile of FIGS. 4a and 4b may appear when the battery cell switches from a discharging state to a no-load state. Alternatively, the cell voltage profile of FIGS. 4a and 4b may appear when the battery cell is in charging.

Referring to FIG. 4a, the cell voltage of a battery cell with a normal voltage gradually increases over time without showing any unusual cell voltage behavior. Therefore, even if an arbitrary cell voltage set $V_k$, $V_{k+1}$, $V_{k+2}$ is selected from the time series data for the cell voltage, the cell voltage set may satisfy the normal diagnosis condition of Formula 4. Therefore, when the time series data for the cell voltage shows the profile as shown in FIG. 4a, the count number of the cell voltage set that does not satisfy the normal diagnosis condition may be 0.

Referring to FIG. 4b, a battery cell exhibiting a voltage abnormality may show an unusual behavior (see $C_2$) in a specific time section. For example, when the battery cell is a lithium-ion battery, when lithium plating occurs at the negative electrode or a tab disconnection of the electrode occurs, the change slope of the cell voltage shows a unique behavior. In other words, there appears a section where the cell voltage slope rather increases while the cell voltage slope is gradually decreasing. Therefore, if the cell voltage set $V_k$, $V_{k+1}$, $V_{k+2}$ is selected in the time section in which an abnormal change pattern of the cell voltage appears, the cell voltage set may not satisfy the normal diagnosis condition of Formula 4. Therefore, when the time series data for the cell voltage shows the profile shown in FIG. 4b, the count number of the cell voltage set that does not satisfy the normal diagnosis condition may be 1. Of course, if an abnormal change pattern of the cell voltage appears at a plurality of locations in the cell voltage profile, the count number of the cell voltage set that does not satisfy the normal diagnosis condition may be increased to the number corresponding to the plurality of locations.

The control circuit 220 may periodically execute the diagnosis logic for detecting the voltage abnormality of the battery cell described above for all battery cells included in the battery pack B. Also, the control circuit 220 may independently execute the diagnosis logic for each battery cell according to a predetermined order when executing diagnosis logics for all battery cells.

The control circuit 220 may also execute in real time the diagnosis logic for detecting the voltage abnormality of the battery cell described above in association with the measurement of cell voltage before obtaining the time series data for the n number of preset cell voltages.

Specifically, when the diagnosis of a voltage abnormality for the battery cell begins, the control circuit 220 may determine whether the cell voltage set $V_1$, $V_2$, $V_3$ satisfies the normal diagnosis condition of Formula 4 when the first, second, and third cell voltages $V_1$, $V_2$, $V_3$ are measured. The measurement period of the cell voltage is the same as $\triangle t$. Also, when the fourth cell voltage $V_4$ is measured, it may be determined whether the cell voltage set $V_2$, $V_3$, $V_4$ satisfies the normal diagnosis condition of Formula 4. This process may be repeated whenever the cell voltage is measured. In other words, when the k+2$^{th}$ cell voltage $V_{k+2}$ is measured, it may be determined whether the cell voltage set $V_k$, $V_{k+1}$, $V_{k+2}$ satisfies the normal diagnosis condition of Formula 4. This diagnostic process may be repeated until the final cell voltage $V_n$ is measured. The total number of cell voltages to be measured may be preset.

The battery diagnosis apparatus 200 according to an embodiment of the present disclosure may be included in a battery management system 100, a control system of a load device (not shown), or a diagnostic system or the like provided in a maintenance center of the vehicle 1 or the battery pack B.

In the present disclosure, the control circuit 220 may optionally include a processor, an application-specific integrated circuit (ASIC), other chipsets, logic circuits, registers, communication modems, data processing devices, etc. known in the art to execute the various control logics described above.

Also, when the control logics are implemented as software, the control circuit 220 may be replaced with a processor that executes a set of program modules. At this time, the program module may be stored in a memory and executed by the processor. The memory may be provided inside or outside the processor, and may be connected to the processor by various well-known computer components. Also, the memory may be included in the storage medium 221. Also, the memory generically refers to a device that stores information regardless of the type of device, and does not refer to a specific memory device.

In addition, one or more of the various control logics of the control circuit 220 are combined, and the combined control logics may be written in a computer-readable code system and recorded on a computer-readable recording medium. The type of the recording medium is not particularly limited as long as it can be accessed by a processor included in a computer. As an example, the recording medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

Hereinafter, a battery diagnosis method using the battery diagnosis apparatus 200 of the present disclosure described above will be described in detail. In one embodiment, the battery diagnosis method may be performed by the battery diagnosis apparatus 200 while the vehicle 1 is operating. In another embodiment, the battery diagnosis method may be performed by the battery diagnosis apparatus 200 while the vehicle 1 is being charged at a charging station. In another embodiment, the battery diagnosis apparatus 200 may be included in a charging station, and a battery diagnosis method may be performed by the battery diagnosis apparatus 200 included in the charging station while the vehicle 1 is being charged at the charging station. The battery diagnosis apparatus 200 included in the charging station may receive the time series data for the cell voltage for the battery cell from the control circuit 220.

The operation of the control circuit 220 will be described in more detail in various embodiment(s) of the battery diagnosis method.

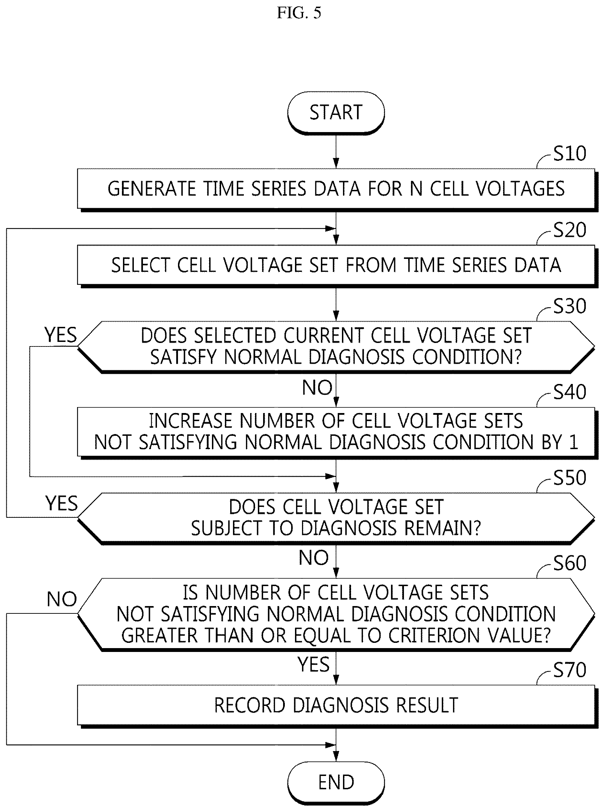

FIG. 5 is a flowchart for exemplarily illustrating a battery diagnosis method according to an embodiment of the present disclosure. The diagnosis method of FIG. 5 may be repeatedly executed for each battery cell included in the battery pack B at each diagnosis cycle preset by the control circuit 220.

Referring to FIG. 5, when the diagnosis starts, the control circuit 220 controls the voltage sensing circuit 210 in the step S10 to repeatedly measure the voltage of the battery cell at regular time intervals ($\triangle t$) so as to generate time series data for the n number of cell voltages and record the same in the storage medium 221.

Subsequently, the control circuit 220 repeats the steps S20 to S50 a preset number of times to determine whether all cell voltage sets selectable from the time series data for the cell voltage satisfy the normal diagnosis condition of Formula 4, thereby accumulatively counting the number of cell voltage sets that do not satisfy the normal diagnosis condition.

First, the control circuit 220 selects a cell voltage set $V_k$, $V_{k+1}$, $V_{k+2}$ from the time series data for the cell voltage in the step S20. Since the current k is 1, the selected cell voltage set is $V_1$, $V_2$, $V_3$.

Subsequently, the control circuit 220 determines whether the current cell voltage set satisfies the normal diagnosis condition of Formula 4 in the step S30.

If the determination in the step S30 is NO, the control circuit 220 accumulatively increases the number of cell voltage sets that do not satisfy the normal diagnosis condition by 1 in the step S40.

Meanwhile, if the determination in the step S30 is YES, the control circuit 220 moves the process to the step S50. The control circuit 220 determines whether a cell voltage set subject to diagnosis remains in the step S50. That is, the control circuit 220 determines whether the current cell voltage set is the last cell voltage set. When the total number of cell voltages included in the time series data is n, the last cell voltage set is $V_{n-2}$, $V_{n-1}$, $V_n$.

If the determination in the step S50 is YES, the control circuit 220 moves the process to the step S20 to select a cell voltage set to be the next diagnostic target, and repeats the S30, S40, and S50 may continuously repeated until the determination in the step S50 is NO.

**[0125]** If all cell voltage sets selectable from the time series data for the cell voltage are completely diagnosed, the control circuit 220 moves the process to the step S60. The control circuit 220 determines whether the number of cell voltage sets counted as not satisfying the normal diagnosis condition of Formula 4 in the step S60 is greater than or equal to the criterion value. The embodiment regarding setting of the criterion value is described above.

If the determination in the step S60 is YES, the control circuit 220 may diagnose that the battery cell exhibits a voltage abnormality and record the diagnosis result in the storage medium 221 in the step S70. The diagnosis result may include the time point at which the voltage abnormality is diagnosed and identification information of the battery cell.

The control circuit 220 may perform voltage abnormality diagnosis for each of the entire battery cells included in the battery pack B. Also, the control circuit 220 may perform the post-diagnosis process by referring to the diagnosis result recorded in the storage medium 221.

That is, the control circuit 220 may transmit the diagnosis result recorded in the storage medium 221 to an external device through the interface unit 330 after the entire battery cells are completely diagnosed. The diagnosis result transmitted to the external device may include the identification information of the battery cell in which a voltage abnormality occurs and information regarding a time point at which the voltage abnormality of the corresponding battery cell is diagnosed. The diagnosis result transmitted to the external device may further include a warning message that the battery pack B requires detailed inspection or a diagnosis code corresponding thereto. As another alternative, the identification information of the battery cell in which a voltage abnormality occurs and detailed information regarding the time point at which the voltage abnormality of the corresponding battery cell is diagnosed may be excluded from the diagnosis result transmitted to the external device. When the external device is a vehicle controller 5, the vehicle controller 5 may output the diagnosis result through a graphical user interface on an integrated display panel mounted on the vehicle 1. When the external device is an on-board diagnosing device that is operably coupled to the interface unit 330, the on-board diagnosing device may output the diagnosis result through the display. At this time, it is desirable that the diagnosis result include a diagnosis code indicating that there is a battery cell exhibiting a voltage abnormality in the battery pack.

In another example, after the entire battery cell is completely diagnosed, the control circuit 220 may output the diagnosis result recorded in the storage medium 221 visually or audibly through the output device 331 operably coupled to the interface unit 330. The diagnosis result output through the output device 331 may include identification information of the battery cell in which a voltage abnormality occurs and information regarding the time point at which the voltage abnormality of the corresponding battery cell is diagnosed. Alternatively, the diagnosis result output through the output device 331 may further include a warning message indicating that the battery pack B needs to be inspected or a diagnosis code corresponding thereto. As another alternative, the identification information of the battery cell in which a voltage abnormality occurs and detailed information regarding the time point at which the voltage abnormality of the corresponding battery cell is diagnosed may be excluded from the diagnosis result output through the output device 331.

When the diagnosis result is output through the output device 331, the user of the vehicle 1 may diagnose the state of the battery pack B more precisely by bringing the vehicle 1 to a service center. If phenomena such as lithium plating are actually confirmed in some of the battery cells included in the battery pack B, the battery pack B may be replaced.

Meanwhile, the battery diagnosis method according to the present disclosure may be modified as follows. In other words, the control circuit 220 may execute the diagnosis cycle in real time in association with the measurement of cell voltage before obtaining time series data for the n number of preset cell voltages.

Specifically, when the diagnosis of voltage abnormality for the battery cell begins, the control circuit 220 performs the steps S30 and S40 for the cell voltage set $V_1$, $V_2$, $V_3$ when the first, second, and third cell voltages $V_1$, $V_2$, $V_3$ are measured. Also, when the fourth cell voltage $V_4$ is measured, the steps S30 and S40 may be executed for the cell voltage set $V_2$, $V_3$, $V_4$. This process may be repeated whenever the cell voltage is measured. In other words, when the $k+2^{th}$ cell voltage $V_{k+2}$ is measured, the steps S30 and S40 may be executed for the cell voltage set $V_k$, $V_{k+1}$, $V_{k+2}$. This diagnostic process may be repeated until the final cell voltage $V_n$ is measured. The total number of cell voltages to be measured may be preset. After the last cell voltage $V_n$ is measured, the steps S60 and S70 may be executed.

The real-time diagnosis logic of the control circuit 220 may be performed in synchronization with the cell voltage measurement process of each battery cell. In addition, when the entire battery cells are completely diagnosed, the control circuit 220 may transmit the diagnosis result to an external device through the interface unit 330 as described above or output the diagnosis result through the output device 331 operably coupled to the interface unit 330 visually or audibly.

According to the embodiments described above, a battery cell exhibiting voltage abnormality may be easily diagnosed by analyzing the tendency of a cell voltage slope between continuously measured cell voltages using a simple mathematical operation.

According to another embodiment of the present disclosure, since the calculation method used for battery diagnosis is not complicated, a processor with high specification is not required.

According to still another embodiment of the present disclosure, the reliability of voltage abnormality diagnosis may be improved by using mathematical operation that may amplify the tendency of the cell voltage slope.

According to still another embodiment of the present disclosure, a battery cell that exhibit abnormal voltage behavior may be reliably identified even if the difference between voltages measured at different time points is not large.

In describing various embodiments of the present disclosure, elements named '... unit' or '... circuit' should be understood as functionally distinct elements rather than physically distinct elements. Thus, each component may be selectively integrated with other components or each component may be divided into sub-components for efficient execution of control logic(s). However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, as many modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications within the scope of the claims.

## Claims

1. A battery diagnosis apparatus (200), comprising:

   a voltage sensing circuit (210) configured to generate a voltage signal indicating a cell voltage of a battery cell ($BC_1$, $BC_N$);
   a storage medium (221) configured to store time series data for the cell voltage; and
   a control circuit (220) operably coupled with the voltage sensing circuit and the storage medium, wherein the control circuit is configured to:

   (i) receive the voltage signal and record the time series data for the cell voltage in the storage medium, **characterised in that** the control circuit is further configured to:
   (ii) select $k^{th}$, $k+1^{th}$, and $k+2^{th}$ measured cell voltage set from the time series data as diagnostic data (k is an index indicating a measurement order of the cell voltage and is a natural number of 1 or more to which a plurality of values is assigned),
   (iii) determine a first voltage difference between the $k^{th}$ cell voltage and the $k+1^{th}$ cell voltage and a second voltage difference between the $k+1^{th}$ cell voltage and the $k+2^{th}$ cell voltage, and
   (iv) diagnose the battery cell as exhibiting a voltage abnormality, when, for a plurality of cell voltage sets, a count number of cell voltage sets for which a normal diagnosis condition where the p square of the first voltage difference (p is a natural number of 1 or more) is greater than the p square of the second voltage difference is not established is greater than or equal to a criterion value.

2. The battery diagnosis apparatus according to claim 1,
   wherein p is 1 or greater.

3. The battery diagnosis apparatus according to claim 1,
   wherein the criterion value is 1 or greater.

4. The battery diagnosis apparatus according to claim 1,
   wherein the control circuit is configured to select the plurality of cell voltage sets from the time series data for the cell voltage while increasing the k by 1 from 1 to n-2 (n is the number of voltage data included in the time series data).

5. The battery diagnosis apparatus according to claim 1,
   wherein the control circuit is configured to perform the control logics (i) to (iv) in response to the operation state of the battery cell switches from a charging or discharging state to a no-load state.

6.  The battery diagnosis apparatus according to claim 1, further comprising:

    an interface unit (330) operably coupled with the control circuit to support communication with an external device,
    wherein the control circuit is configured to transmit a diagnosis result to an external device through the interface unit in response to the battery cell is diagnosed as exhibiting a voltage abnormality.

7.  The battery diagnosis apparatus according to claim 1, further comprising:

    an interface unit (330) operably coupled with the control circuit; and
    an output device (331) operably coupled with the interface unit,
    wherein the control circuit is configured to output a diagnosis result visually or audibly through the output device in response to the battery cell is diagnosed as exhibiting a voltage abnormality.

8.  A battery pack (B), comprising the battery diagnosis apparatus according to any one of claims 1 to 7.

9.  A vehicle (1), comprising the battery pack according to claim 8.

10. A battery diagnosis method, comprising:

    (a) receiving from a voltage sensing circuit a voltage signal indicating a cell voltage of a battery cell recording time series data for the cell voltage in a storage medium;

    **characterised by**:

    (b) selecting $k^{th}$, $k+1^{th}$, and $k+2^{th}$ measured cell voltage set from the time series data as diagnostic data (k is an index indicating a measurement order of the cell voltage and is a natural number of 1 or more to which a plurality of values is assigned);
    (c) determining a first voltage difference between the $k^{th}$ cell voltage and the $k+1^{th}$ cell voltage and a second voltage difference between the $k+1^{th}$ cell voltage and the $k+2^{th}$ cell voltage; and
    (d) diagnosing the battery cell as exhibiting a voltage abnormality, when, for a plurality of cell voltage sets, a count number of cell voltage sets for which a normal diagnosis condition where the p square of the first voltage difference (p is a natural number of 1 or more) is greater than the p square of the second voltage difference is not established is greater than or equal to a criterion value.

11. The battery diagnosis method according to claim 10, wherein p is 1 or greater.

12. The battery diagnosis method according to claim 10, wherein the criterion value is 1 or greater.

13. The battery diagnosis method according to claim 10, wherein the plurality of cell voltage sets are selected from the time series data for the cell voltage while increasing the k by 1 from 1 to n-2 (n is the number of voltage data included in the time series data).

14. The battery diagnosis method according to claim 10, wherein the steps (a) to (d) are performed in response to the operation state of the battery cell switches from a charging or discharging state to a no-load state.

15. The battery diagnosis method according to claim 10, further comprising:
    transmitting a diagnosis result to an external device in response the battery cell is diagnosed as exhibiting a voltage abnormality.

**Patentansprüche**

1.  Batterie-Diagnosevorrichtung (200), umfassend:

    eine Spannung-Erfassungsschaltung (210), welche dazu eingerichtet ist, ein Spannungssignal zu erzeugen, welches eine Zellenspannung einer Batteriezelle ($BC_1$, $BC_N$) anzeigt;
    ein Speichermedium (221), welches dazu eingerichtet ist, Zeitserien-Daten für die Zellenspannung zu speichern; und
    eine Steuerschaltung (220), welche betriebsmäßig mit der Spannung-Erfassungsschaltung und dem Speichermedium gekoppelt ist,
    wobei die Steuerschaltung dazu eingerichtet ist:

    (i) das Spannungssignal zu erhalten und die Zeitserien-Daten für die Zellenspannung in dem Speichermedium aufzuzeichnen, **dadurch gekennzeichnet, dass** die Steuerschaltung ferner dazu eingerichtet ist:
    (ii) k-te, k+1-te und k+2-te gemessene Zellspannung-Sätze aus den Zeitserien-Daten als Diagnosedaten auszuwählen (k ist ein Index, welcher eine Messreihenfolge der Zellenspannung anzeigt, und ist eine natürliche Zahl von 1 oder mehr, welcher eine Mehrzahl von Werten zugeordnet ist),

(iii) eine erste Spannungsdifferenz zwischen der k-ten Zellenspannung und der k+1-ten Zellenspannung und eine zweite Spannungsdifferenz zwischen der k+1-ten Zellenspannung und der k+2-ten Zellenspannung zu bestimmen, und

(iv) zu diagnostizieren, dass die Batteriezelle eine Spannungsanomalie zeigt, wenn für eine Mehrzahl von Zellenspannung-Sätzen eine Zählanzahl von Zellenspannung-Sätzen, für welche eine normale Diagnosebedingung, in welcher das p-Quadrat der ersten Spannungsdifferenz (p ist eine natürliche Zahl von 1 oder mehr) größer als das p-Quadrat der zweiten Spannungsdifferenz ist, nicht als größer oder gleich einem Kriteriumswert etabliert wird.

2. Batterie-Diagnosevorrichtung nach Anspruch 1, wobei p 1 oder größer ist.

3. Batterie-Diagnosevorrichtung nach Anspruch 1, wobei der Kriteriumswert 1 oder größer ist.

4. Batterie-Diagnosevorrichtung nach Anspruch 1, wobei die Steuerschaltung dazu eingerichtet ist, die Mehrzahl von Zellenspannung-Sätzen aus den Zeitserien-Daten für die Zellenspannung auszuwählen, während das k um 1 von 1 zu n-2 erhöht wird (n ist die Anzahl von Spannungsdaten, welche in den Zeitserien-Daten umfasst sind).

5. Batterie-Diagnosevorrichtung nach Anspruch 1, wobei die Steuerschaltung dazu eingerichtet ist, die Steuerlogiken (i) bis (iv) in Reaktion darauf durchzuführen, dass der Betriebszustand der Batteriezelle von einem Lade- oder Entladezustand zu einem nicht-Ladezustand umschaltet.

6. Batterie-Diagnosevorrichtung nach Anspruch 1, ferner umfassend:

eine Schnittstellen-Einheit (330), welche betriebsmäßig mit der Steuerschaltung gekoppelt ist, um eine Kommunikation mit einer externen Vorrichtung zu unterstützen, wobei die Steuerschaltung dazu eingerichtet ist, ein Diagnoseergebnis zu einer externen Vorrichtung durch die Schnittstelleneinheit in Reaktion darauf zu übertragen, dass diagnostiziert wird, dass die Batteriezelle eine Spannungsanomalie zeigt.

7. Batterie-Diagnosevorrichtung nach Anspruch 1, ferner umfassend:

eine Schnittstellen-Einheit (330), welche betriebsmäßig mit der Steuerschaltung gekoppelt ist; und
eine Ausgabevorrichtung (331), welche betriebsmäßig mit der Schnittstellen-Einheit gekoppelt ist,
wobei die Steuerschaltung dazu eingerichtet ist, ein Diagnoseergebnis visuell oder
akustisch durch die Ausgabevorrichtung in Reaktion darauf auszugeben, dass diagnostiziert wird, dass die Batteriezelle eine Spannungsanomalie zeigt.

8. Batteriepack (B), umfassend die Batterie-Diagnosevorrichtung nach einem der Ansprüche 1 bis 7.

9. Fahrzeug (1), umfassend den Batteriepack nach Anspruch 8.

10. Batterie-Diagnoseverfahren, umfassend:

(a) Erhalten eines Spannungssignals von einer Spannung-Erfassungsschaltung, welches eine Zellenspannung einer Batteriezelle anzeigt, wobei Zeitserien-Daten für die Zellenspannung in einem Speichermedium aufgezeichnet werden; **gekennzeichnet durch**:
(b) Auswählen von k-ten, k+1-ten und k+2-ten gemessenen Zellspannung-Sätzen aus den Zeitserien-Daten als Diagnosedaten (k ist ein Index, welcher eine Messreihenfolge der Zellenspannung anzeigt, und ist eine natürliche Zahl von 1 oder mehr, welcher eine Mehrzahl von Werten zugeordnet ist),
(c) Bestimmen einer ersten Spannungsdifferenz zwischen der k-ten Zellenspannung und der k+1-ten Zellenspannung und einer zweiten Spannungsdifferenz zwischen der k+1-ten Zellenspannung und der k+2-ten Zellenspannung; und
(d) Diagnostizieren, dass die Batteriezelle eine Spannungsanomalie zeigt, wenn für eine Mehrzahl von Zellenspannung-Sätzen eine Zählanzahl von Zellenspannung-Sätzen, für welche eine normale Diagnosebedingung, in welcher das p-Quadrat der ersten Spannungsdifferenz (p ist eine natürliche Zahl von 1 oder mehr) größer als das p-Quadrat der zweiten Spannungsdifferenz ist, nicht als größer oder gleich einem Kriteriumswert etabliert wird.

11. Batterie-Diagnoseverfahren nach Anspruch 10, wobei p 1 oder größer ist.

12. Batterie-Diagnoseverfahren nach Anspruch 10, wobei der Kriteriumswert 1 oder größer ist.

13. Batterie-Diagnoseverfahren nach Anspruch 10, wobei die Mehrzahl von Zellenspannung-Sätzen aus den Zeitserien-Daten für die Zellenspannung ausgewählt werden, während das k um 1 von 1 zu n-2 erhöht wird (n ist die Anzahl von Spannungsdaten, welche in den Zeitserien-Daten umfasst sind).

14. Batterie-Diagnoseverfahren nach Anspruch 10, wobei die Schritte (a) bis (d) in Reaktion darauf durchgeführt werden, dass der Betriebszustand der Batteriezelle von einem Lade- oder Entladezustand zu einem nicht-Ladezustand umschaltet.

15. Batterie-Diagnoseverfahren nach Anspruch 10, ferner umfassend:
Übertragen eines Diagnoseergebnisses zu einer externen Vorrichtung in Reaktion darauf, dass diagnostiziert wird, dass die Batteriezelle eine Spannungsanomalie zeigt.

**Revendications**

1. Appareil de diagnostic de batterie (200), comprenant :

un circuit de détection de tension (210) configuré pour générer un signal de tension indiquant une tension de cellule d'une cellule de batterie ($BC_1$, $BC_N$) ;
un support de stockage (221) configuré pour stocker des données de série chronologique pour la tension de cellule ; et
un circuit de commande (220) couplé de manière fonctionnelle au circuit de détection de tension et au support de stockage,
dans lequel le circuit de commande est configuré pour :

(i) recevoir le signal de tension et enregistrer les données de série chronologique pour la tension de cellule dans le support de stockage, **caractérisé en ce que** le circuit de commande est en outre configuré pour :
(ii) sélectionner, en tant que données de diagnostic, un ensemble de $k^{ième}$, $k+1^{ième}$ et $k+2^{ième}$ tensions de cellule mesurées parmi les données de série chronologique (k est un indice indiquant un ordre de mesure de la tension de cellule et est un nombre naturel supérieur ou égal à 1 auquel une pluralité de valeurs sont attribuées),
(iii) déterminer une première différence de tension entre la $k^{ième}$ tension de cellule et la $k+1^{ième}$ tension de cellule et une seconde différence de tension entre la $k+1^{ième}$ tension de cellule et la $k+2^{ième}$ tension de cellule, et
(iv) diagnostiquer la cellule de batterie comme présentant une anomalie de tension, lorsque, pour une pluralité d'ensembles de tensions de cellule, un nombre de comptages d'ensembles de tensions de cellule pour lesquels une condition de diagnostic normale dans laquelle le carré p de la première différence de tension (p est un nombre naturel supérieur ou égal à 1) est supérieur au carré p de la seconde différence de tension n'est pas établie est supérieur ou égal à une valeur de critère.

2. Appareil de diagnostic de batterie selon la revendication 1,
dans lequel p est supérieur ou égal à 1.

3. Appareil de diagnostic de batterie selon la revendication 1,
dans lequel la valeur de critère est supérieure ou égale à 1.

4. Appareil de diagnostic de batterie selon la revendication 1,
dans lequel le circuit de commande est configuré pour sélectionner la pluralité d'ensembles de tensions de cellule parmi les données de série chronologique pour la tension de cellule tout en augmentant la valeur k de 1, de 1 à n-2 (n est le nombre de données de tension incluses dans les données de série chronologique).

5. Appareil de diagnostic de batterie selon la revendication 1,
dans lequel le circuit de commande est configuré pour réaliser les logiques de commande (i) à (iv) en réponse au fait que l'état de fonctionnement de la cellule de batterie passe d'un état de charge ou de décharge à un état à vide.

6. Appareil de diagnostic de batterie selon la revendication 1, comprenant en outre :

une unité d'interface (330) couplée de manière fonctionnelle au circuit de commande pour soutenir la communication avec un dispositif externe,
dans lequel le circuit de commande est configuré pour transmettre un résultat de diagnostic à un dispositif externe par l'intermédiaire de l'unité d'interface en réponse au fait que la cellule de batterie est diagnostiquée comme présentant une anomalie de tension.

7. Appareil de diagnostic de batterie selon la revendication 1, comprenant en outre :

une unité d'interface (330) couplée de manière fonctionnelle au circuit de commande ; et

un dispositif de sortie (331) couplé de manière fonctionnelle à l'unité d'interface,

dans lequel le circuit de commande est configuré pour délivrer en sortie un résultat de diagnostic de façon visuelle ou audible par le biais du dispositif de sortie en réponse au fait que la cellule de batterie est diagnostiquée comme présentant une anomalie de tension.

8. Bloc-batterie (B), comprenant l'appareil de diagnostic de batterie selon l'une quelconque des revendications 1 à 7.

9. Véhicule (1), comprenant le bloc-batterie selon la revendication 8.

10. Procédé de diagnostic de batterie, comprenant :

(a) la réception, en provenance d'un circuit de détection de tension, d'un signal de tension indiquant une tension de cellule d'une cellule de batterie enregistrant des données de série chronologique pour la tension de cellule dans un support de stockage ; **caractérisé par** :
(b) la sélection en tant que données de diagnostic, d'un ensemble de $k^{ième}$, $k+1^{ième}$ et $k+2^{ième}$ tensions de cellule mesurées parmi les données de série chronologique (k est un indice indiquant un ordre de mesure de la tension de cellule et est un nombre naturel supérieur ou égal à 1 auquel une pluralité de valeurs sont attribuées) ;
(c) la détermination d'une première différence de tension entre la $k^{ième}$ tension de cellule et la $k+1^{ième}$ tension de cellule et d'une seconde différence de tension entre la $k+1^{ième}$ tension de cellule et la $k+2^{ième}$ tension de cellule ; et
(iv) le diagnostic de la cellule de batterie comme présentant une anomalie de tension, lorsque, pour une pluralité d'ensembles de tensions de cellule, un nombre de comptages d'ensembles de tensions de cellule pour lesquels une condition de diagnostic normale dans laquelle le carré p de la première différence de tension (p est un nombre naturel supérieur ou égal à 1) est supérieur au carré p de la seconde différence de tension n'est pas établie est supérieur ou égal à une valeur de critère.

11. Procédé de diagnostic de batterie selon la revendication 10,
dans lequel p est supérieur ou égal à 1.

12. Procédé de diagnostic de batterie selon la revendication 10,
dans lequel la valeur de critère est supérieure ou égale à 1.

13. Procédé de diagnostic de batterie selon la revendication 10,
dans lequel la pluralité d'ensembles de tensions de cellule sont sélectionnés parmi les données de série chronologique pour la tension de cellule tout en augmentant la valeur k de 1, de 1 à n-2 (n est le nombre de données de tension incluses dans les données de série chronologique).

14. Procédé de diagnostic de batterie selon la revendication 10,
dans lequel les étapes (a) à (d) sont réalisées en réponse au fait que l'état de fonctionnement de la cellule de batterie passe d'un état de charge ou de décharge à un état à vide.

15. Procédé de diagnostic de batterie selon la revendication 10, comprenant en outre : la transmission d'un résultat de diagnostic à un dispositif externe en réponse au fait que la cellule de batterie est diagnostiquée comme présentant une anomalie de tension.

FIG. 1

FIG. 2a

FIG. 2b

FIG. 3a

FIG. 3b

FIG. 4a

FIG. 4b

FIG. 5

```
                    ┌──────────┐
                    │  START   │
                    └────┬─────┘
                         │                        ┌S10
   ┌─────────────────────▼──────────────────────────────┐
   │   GENERATE TIME SERIES DATA FOR N CELL VOLTAGES     │
   └─────────────────────┬──────────────────────────────┘
   │                     │                        ┌S20
   │  ┌──────────────────▼──────────────────────────────┐
   │  │   SELECT CELL VOLTAGE SET FROM TIME SERIES DATA  │
   │  └──────────────────┬──────────────────────────────┘
   │                     │                        ┌S30
   │  YES  ┌─────────────▼──────────────────────────────┐
   │◄──────┤   DOES SELECTED CURRENT CELL VOLTAGE SET    │
   │       │   SATISFY NORMAL DIAGNOSIS CONDITION?       │
   │       └─────────────┬──────────────────────────────┘
   │                   NO │                       ┌S40
   │  ┌──────────────────▼──────────────────────────────┐
   │  │       INCREASE NUMBER OF CELL VOLTAGE SETS       │
   │  │  NOT SATISFYING NORMAL DIAGNOSIS CONDITION BY 1  │
   │  └──────────────────┬──────────────────────────────┘
   │                     │                        ┌S50
   │  YES  ┌─────────────▼──────────────────────────────┐
   └───────┤           DOES CELL VOLTAGE SET             │
           │         SUBJECT TO DIAGNOSIS REMAIN?        │
           └─────────────┬──────────────────────────────┘
                       NO │                       ┌S60
      NO   ┌─────────────▼──────────────────────────────┐
   ┌───────┤         IS NUMBER OF CELL VOLTAGE SETS      │
   │       │   NOT SATISFYING NORMAL DIAGNOSIS CONDITION │
   │       │  GREATER THAN OR EQUAL TO CRITERION VALUE?  │
   │       └─────────────┬──────────────────────────────┘
   │                  YES │                       ┌S70
   │       ┌─────────────▼──────────────────────────────┐
   │       │            RECORD DIAGNOSIS RESULT          │
   │       └─────────────┬──────────────────────────────┘
   │                     │
   └─────────────────────▼
                    ┌──────────┐
                    │   END    │
                    └──────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220117336

- US 2022128631 A1